# EUROPEAN PATENT APPLICATION

(11) **EP 2 615 890 A1**
(43) Date of publication of application: **17.07.2013**
(21) Application number: 12195946.4
(22) Date of filing: 06.12.2012
(51) Int. Cl.: H05K 1/11, H05K 3/40

(54) **Circuit board having board to board connector and method of manufacturing the same**

(30) Priority: 13.01.2012 KR 20120004391
(71) Applicant: Samsung Electronics Co., Ltd, Gyeonggi-do 443-742 (KR)
(72) Inventor: Hong, Sungwon, 443-742 Gyeonggi-do, (KR)
(74) Representative: Harrison Goddard Foote LLP

(57) **Abstract**

A circuit board having a board-to-board connector and a method of manufacturing the same are provided. The circuit board includes at least one of a recess and a hole having a connection portion exposed to be electrically connected to a connection portion of a connector header of another circuit board, a terminal on the circuit board, and a conduction line for connecting the terminal and the connection portion. Thereby, a cost and required space for a board-to-board connection can be reduced.

## Description

### BACKGROUND OF THE INVENTION

### 1. Field of the Invention:

The present invention relates to a circuit board having a board-to-board connector and a method of manufacturing the same. More particularly, the present invention relates to a circuit board and a method of manufacturing the same that reduces the cost and required space for a board-to-board connection.

### 2. Description of the Related Art:

In general, a circuit board is a board in which a circuit is formed thereon. In the circuit board, particularly, a Printed Circuit Board (PCB) is a thin plate in which a chip or other electronic components are installed thereon. The board is made of reinforced fiber glass or plastic, and components are connected through a circuit made of copper. A major PCB within a system is referred to as a system board or a motherboard, and a small component inserted into a slot of a main board is referred to as a board or a card. A PCB of the 1960s connected together separated components. A PCB of the 1990s connected several chips, wherein each chip included hundreds of thousands and millions of basic electronic elements.

Other similar circuit boards instead of the PCB may be used. Hereinafter, for convenience, the PCB is described, however the present invention is not limited thereto.

When PCBs for a portable terminal are connected, a board-to-board connector is used.

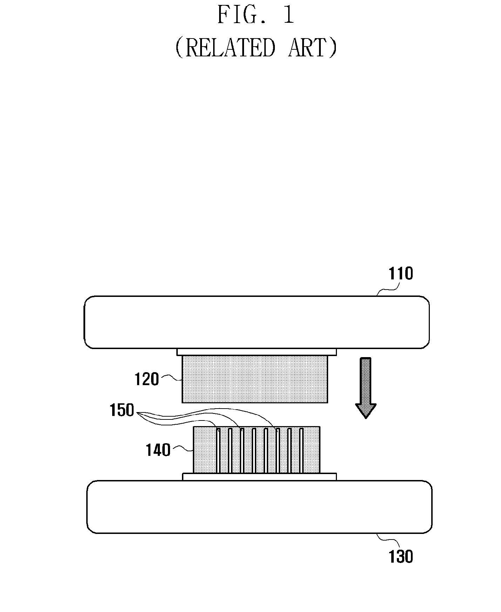

FIG. 1 is a diagram illustrating a board-to-board connection according to the related art.

Referring to FIG. 1, a connection socket 120 is disposed on a first PCB 110. Further, a connector header 140 is disposed on a second PCB 130. A connection portion 150 is disposed at an outer surface of the connector header 140. The connection portion 150 of the connector header 140 is formed with an electrical conductor. When the connection portion 150 of the connector header 140 and a connection portion within the connection socket 120 are combined to contact, the connection portions of the connector header 140 and the connection socket 120 can be electrically combined.

According to the method of FIG. 1, a pair of the connector header 140 and the connection socket 120 are used for a board-to-board connection. Further, for a board-to-board connection, space corresponding to a height of the connector header 140 and the connection socket 120 is required.

Therefore, a need exists for a circuit board and a method of manufacturing the same that reduces the cost and required space for a board-to-board connection.

The above information is presented as background information only to assist with an understanding of the present disclosure. No determination has been made, and no assertion is made, as to whether any of the above might be applicable as prior art with regard to the present invention.

### SUMMARY OF THE INVENTION

Aspects of the present invention are to address the above-mentioned problems and/or disadvantages and to provide at least the advantages described below. Accordingly, an aspect of the present invention is to provide a circuit board and a method of manufacturing the same that can reduce a cost and required space for a board-to-board connection.

In accordance with an aspect of the present invention, a circuit board is provided. The circuit board includes at least one of a recess and a hole having a connection portion exposed to electrically connect to a connection portion of a connector header of another circuit board, a terminal on the circuit board, and a conduction line for connecting the terminal and the connection portion.

Preferably, the connection portion is formed in an inner wall of the at least one of the recess and the hole.

Preferably, the connection portion exists in plural and extends in a thickness direction of the circuit board.

Preferably, the connection portion is protrudes from an inner wall of the at least one of the recess and the hole.

Preferably, the at least one of the recess and the hole is operatively connected with the connector header by inserting the connector header therein.

In accordance with another aspect of the present invention, a method of manufacturing a circuit board is provided. The method includes preparing a circuit board, forming a circuit such that a conduction line passes through an interface of a position at which the circuit board is to be at least one of bored and recessed, and forming at least one of a recess and a hole such that a connection portion of the conduction line is exposed to be electrically connected to a connection portion of a connector header of another circuit board.

In accordance with another aspect of the present invention, an apparatus for manufacturing a circuit board is provided. The apparatus includes a circuit board and a combining target circuit board. The circuit board includes at least one of a recess and a hole having a connection portion, a terminal, and a conduction line for connecting the terminal and the connection portion. The combining target circuit board includes a connector header having a combining target connection portion, a combining target terminal, and another conduction line for connecting the combining target terminal and the combining target connection portion. The at least one of the recess and the hole and the connector header are operatively connected by inserting the connector header into the at least one of the recess and the hole, and the connection portion is electrically connected to the combining target connection portion.

In accordance with another aspect of the present invention, a method of manufacturing a circuit board is provided. The method includes preparing a circuit board including at least one of a recess and a hole having a connection portion, a terminal, and a conduction line for connecting the terminal and the connection portion; preparing a combining target circuit board including a connector header having a combining target connection portion, a combining target terminal, and another conduction line for connecting the combining target terminal and the combining target connection portion, and operatively connecting the at least one of the recess and the hole and the connector header by inserting the connector header into the at least one of the recess and the hole such that the connection portion is electrically connected to the combining target connection portion.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following description taken in conjunction with the accompanying drawings, in which:

FIG. 1 is a diagram illustrating a board-to-board connection according to the related art;

FIG. 2A is a plan view illustrating a Printed Circuit Board (PCB) according to an exemplary embodiment of the present invention;

FIG. 2B is a cross-sectional view illustrating the PCB taken along line A-B of FIG. 2A;

FIG. 3A is a side view illustrating a connection between a PCB and another PCB before the PCB and the another PCB are connected according to an exemplary embodiment of the present invention;

FIG. 3B is a side view illustrating a connection between a PCB and another PCB according to an exemplary embodiment of the present invention;

FIG. 4 is a flowchart illustrating a process of manufacturing a PCB such as, for example, the PCB of FIG. 2A according to an exemplary embodiment of the present invention; and

FIG. 5 is a schematic diagram illustrating a process of manufacturing a PCB such as, for example, the PCB of FIG. 2A according to an exemplary embodiment of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

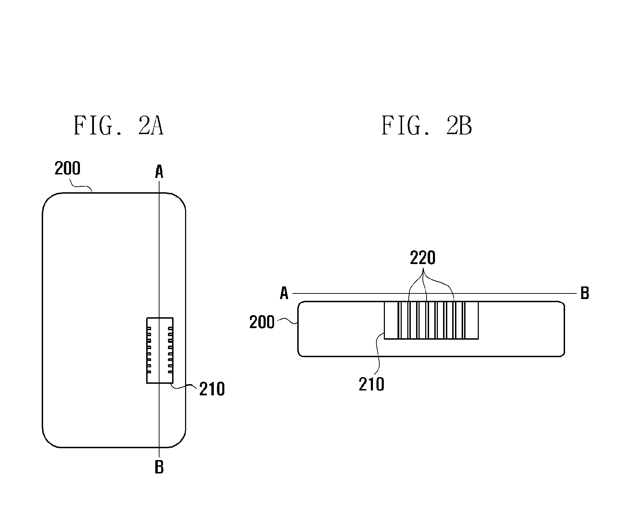

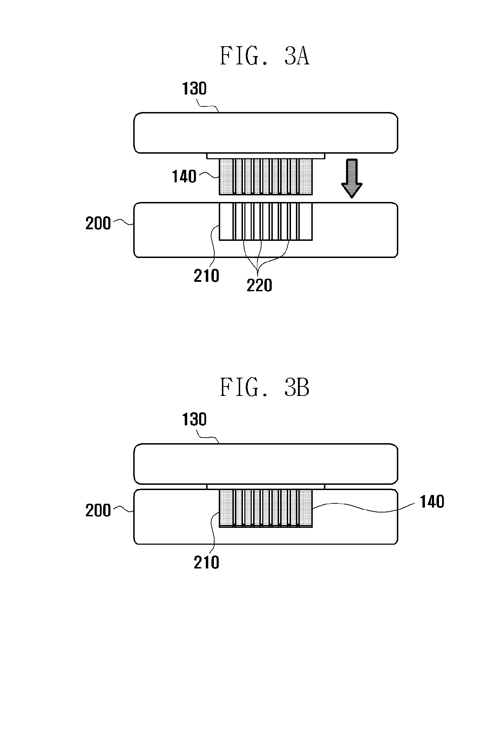

FIG. 2A is a plan view illustrating a Printed Circuit Board (PCB) 200 according to an exemplary embodiment of the present invention, FIG. 2B is a cross-sectional view illustrating the PCB 200 taken along line A-B of FIG. 2A, FIG. 3A is a side view illustrating a connection between the PCB 200 and another PCB 130 before the PCB 200 and the PCB 130 are connected according to an exemplary embodiment of the present invention, and FIG. 3B is a side view illustrating a connection between the PCB 200 and another PCB 130 according to an exemplary embodiment of the present invention.

Referring to FIGs. 2A and 2B, the PCB 200 has a recess 210 therein. The recess 210 may be formed in, for example a rectangular shape. The recess 210 substantially performs a function of a connection socket. For example, as shown in FIGs. 3A and 3B, the recess 210 and a connector header 140 of the another PCB 130 are combined. For this, it is preferable that a shape of the recess 210 is formed such that the connector header 140 and PCB 200 and the PCB 130 are connected when the connector header 140 is inserted into the recess 210 (e.g., combines with inserting).

Hereinafter, in this specification, combination with inserting is referred to as a connection or a combination in which a receded shape of the recess 210 and a shape of the connector header 140 substantially correspond and in which a connection state is sustained by a frictional force or a force similar thereto when the connector header 140 is inserted into the recess 210. It is preferable that the connector header 140 and/or the recess 210 have (has) appropriate elasticity for smooth connection of the PCB 200 with the PCB 130. When the connector header 140 and/or the recess 210 have (has) appropriate elasticity, by partially changing a shape of the connector header 140 and/or the recess 210, the connector header 140 can be inserted into the recess 210, and when insertion of the connector header 140 is terminated, the connector header 140 attempts to expand and the recess 210 attempts to contract and thus the connector header 140 is well combined without separation by a frictional force.

A connection portion 220 is exposed at an inner wall (side surface) of the recess 210. The connection portion 220 is electrically connected to another terminal or another part of the PCB 200 through a conduction line within the PCB 200. A plurality of connection portions 220 are exposed at an inner wall (side surface) of one recess 210. In this case, it is preferable that each connection portion 220 is electrically separated.

The connection portion 220 is extended in a thickness direction of the PCB 200. For example, the connection portion 220 is formed in a long extended line form in a thickness direction of the PCB 200.

Referring to FIGs. 3A and 3B, the connector header 140 is connected with the recess 210 from the upside to the downside. For example, the connector header is combined with the recess 210 by inserting the connector header 140 into the recess 210. Therefore, a combining depth may be changed due to a connection state or other reasons. When the connection portion 220 is extended in a thickness direction of the PCB 200, even if a combining depth is somewhat changed, a connection state can be guaranteed. Further, because the connection portion 220 is extended in a thickness direction of the PCB 200, even if a combining depth is somewhat changed, the connection portion 220 is connected to a corresponding connection portion of the connector header 140.

The connection portion 220 protrudes from an inner wall of the recess 210. When the connection portion 220 protrudes from an inner wall of the recess 210, a contact failure of the connection portion 220 can be prevented.

A combining target PCB 130 has the connector header 140. The connector header 140 may have a plurality of connection portions 150. In this case, it is preferable that each connection portion 150 is electrically separated.

The connector header 140 and the recess 210 should have a corresponding shape for connection of the connection header 140 with the recess 210. For example, the connector header 140 and the recess 210 should have a corresponding shape to allow for the connector header 140 to be inserted into the recess 210. Further, a connection portion is formed at a corresponding position of a surface of the connector header 140 and an inner wall of the recess 210. As shown in FIG. 3B, when the connector header 140 and the recess 210 are connected when the connector header 140 is inserted into the recess 210, a connection portion of a surface of the connector header 140 and the connection portion 220 of an inner wall of the recess 210 of a position corresponding thereto are electrically connected.

In the foregoing exemplary embodiment of the present invention, it is described that the PCB 200 has the recess 210. However, a modified example in which a hole is formed at the same position instead of the recess 210 may be performed. For example, in a cross-sectional view of FIG. 2B, all portions under the recess 210 may be formed as empty space (e.g., a recess). Even in this case, a problem does not occur when connecting to the connector header 140. Further, it may be easier and cheaper to bore an entire thickness than to remove only a portion of a board thickness according to a process method.

As in the process of FIGs. 3A and 3B, when preparing the PCB 200 and the combining target PCB 130 and connecting the connector header 140 with the recess 210 (e.g., when the connector header 140 is inserted into the recess 210), a structure in which the PCB 200 and the combining target PCB 130 are connected can be manufactured.

The PCB 200 has the recess 210 or a hole and may be thus referred to as a recess circuit board. Further, the combining target PCB 130 has the protruded connector header 140 and may be thus referred to as a protrusion circuit board.

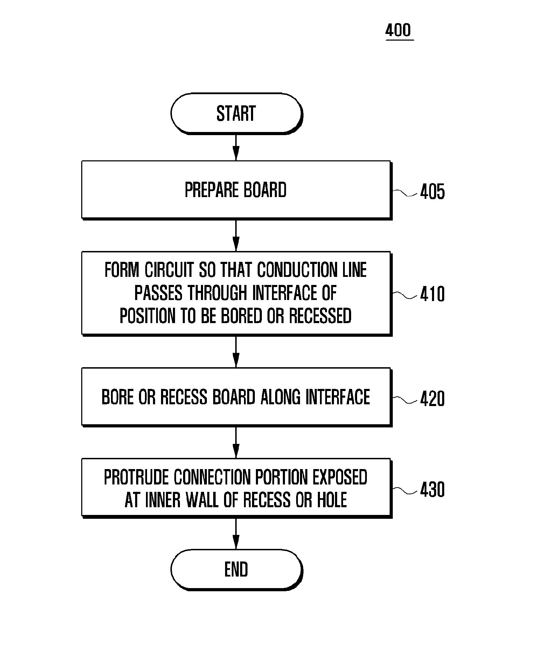

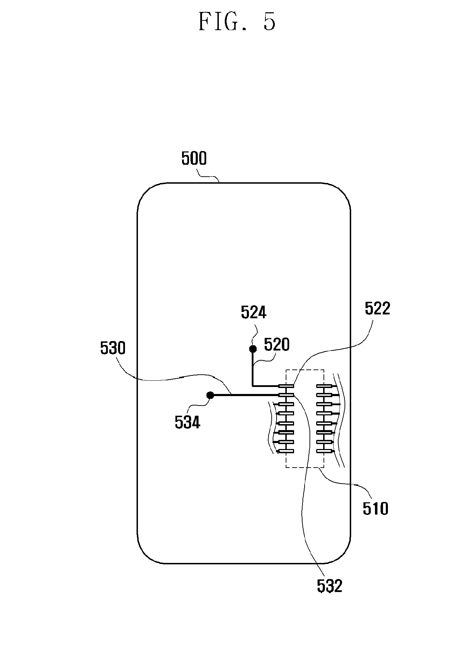

FIG. 4 is a flowchart illustrating a process of manufacturing a PCB 400 such as, for example, the PCB of FIG. 2A according to an exemplary embodiment of the present invention, and FIG. 5 is a schematic diagram illustrating a process of manufacturing a PCB such as, for example, the PCB of FIG. 2A according to an exemplary embodiment of the present invention.

Referring to FIG. 4, a circuit board production apparatus prepares a PCB at step 405. The circuit board production apparatus forms a circuit so that a conduction line passes through an interface of a position to be bored or recessed at step 410.

FIG. 5 illustrates a PCB 500. Conduction lines 520 and 530 are positioned at the inside and the outside of the PCB 500. The conduction lines 520 and 530 are designed to pass through a boundary line 510 of a position to be bored or recessed. Only two conduction lines 520 and 530 are described, however, more conduction lines may actually pass through the boundary line 510 of a position to be bored or recessed. An interface of a position to be bored or recessed is formed so that the connector header 140 is connected (e.g., when the connector header 140 is inserted).

The circuit board production apparatus bores or recesses the PCB 500 along a preset interface at step 420. Thereby, a recess or a hole is formed. The conduction lines 520 and 530 passes through the boundary line 510 of a bored or recessed position. Therefore, after step 420, connection portions 522 and 532 of the conduction lines 520 and 530 are exposed at an inner wall of the hole or the recess. One connection portion 522 is connected to a terminal 524 through one conduction line 520, and the other connection portion 532 is connected to the other terminal 534 through the other conduction line 530.

The circuit board production apparatus protrudes a connection portion exposed at an inner wall of the recess or the hole at step 430. When the connection portion is not protruded further than other portion of an inner wall of the recess or the hole, if the connection portion is combined to the connector header 140, a connection may not be smoothly performed. Therefore, the circuit board production apparatus can protrude a connection portion exposed at an inner wall of the recess or the hole with a method of cutting out an insulator portion of an inner wall of the recess or the hole or a method of attaching and increasing a conductor in an inside direction of a recess or hole from the connection portions 522 and 532.

Step 430 may be omitted according to a modified exemplary embodiment of the present invention. For example, at step 420, the circuit board production apparatus may form a hole or a recess to protrude a connection portion. In this case, a process of step 430 is unnecessary.

According to another modified exemplary embodiment of the present invention, a long electrode may be attached to the connection portions 522 and 532 in a thickness direction of the PCB 500 so that connection portions 522 and 532 of an inner wall of the recess or the hole may extend in a thickness direction of the PCB 500. However, in the PCB prepared at step 410, when the internal conduction lines 520 and 530 are prepared to be formed along a thickness direction of the PCB 500 at a position of the boundary line 510, attachment of a separate electrode is unnecessary.

In a description of FIGs. 2A and 2B, a description of the conduction lines 520 and 530 and terminals 524 and 534 is omitted, however the PCB 200 of FIGs. 2A and 2B may have a conduction line and a terminal.

A form of the recess or the hole according to exemplary embodiments of the present invention illustrated in FIGs. 2A to 5 is an illustrative example, and a form of the recess or the hole can be changed according to a shape of a connector header to be connected or combined. Further, the quantity or a position of a connection portion of an inner wall of the recess or the hole according to exemplary embodiments of the present invention illustrated in FIGs. 2A to 5 can be changed according to the quantity or a position of a connection portion of a connector header to be connected or combined. In FIGs. 2A and 5, protrusion of connection portions 220, 522, and 532 is somewhat excessively expressed, however a protrusion length of the connection portion 220, 522, and 532 may be actually shorter than a size of the recess or the hole.

As described above, when a connection portion is exposed at a recess or a hole within the PCB, a connection socket for connecting to a connector header may be omitted and thus a cost can be reduced. Further, according to exemplary embodiments of the present invention, space corresponding to a height of a connection socket/connector header for a connection between PCBs can be saved.

As described above, in a circuit board and a method of manufacturing the same according to exemplary embodiment of the present invention, a cost and required space for a board-to-board connection can be reduced.

While the invention has been shown and described with reference to certain exemplary embodiments thereof, it will be understood by those skilled in the art that various changes in form and details may be made therein without departing from the spirit and scope of the exemplary embodiments of the present invention as defined in the appended claims and their equivalents.

## Claims

1. A circuit board comprising:
at least one of a recess and a hole having a connection portion exposed to be electrically connected to a connection portion of a connector header of another circuit board;
a terminal on the circuit board; and
a conduction line for connecting the terminal and the connection portion.

2. The circuit board of claim 1, wherein the connection portion is formed in an inner wall of the at least one of the recess and the hole.

3. The circuit board of claim 1 or claim 2, wherein the connection portion is formed in plural and extends in a thickness direction of the circuit board.

4. The circuit board of one of claims 1 to 3, wherein the connection portion protrudes from an inner wall of the at least one of the recess and the hole.

5. The circuit board of one of claims 1 to 4, wherein the at least one of the recess and the hole is operatively connected with the connector header by inserting the connector header therein.

6. The circuit board of one of claims 1 to 5, further comprising:
a combining target circuit board comprising a connector header having a combining target connection portion, a combining target terminal, and another conduction line for connecting the combining target terminal and the combining target connection portion,
wherein the at least one of the recess and the hole and the connector header are operatively connected by inserting the connector header into the at least one of the recess and the hole, and the connection portion is electrically connected to the combining target connection portion.

7. A method of manufacturing a circuit board, the method comprising:
preparing a board;
forming a circuit such that a conduction line passes through an interface of a position at which the circuit board is to be at least one of bored and recessed; and
forming at least one of a recess and a hole such that a connection portion of the conduction line is exposed to be electrically connected to a connection portion of a connector header of another circuit board.

8. The method of claim 7, wherein the connection portion is formed in an inner wall of the at least one of the recess and the hole.

9. The method of claim 7 or claim 8, wherein the connection portion corresponds to a plurality of connection portions that extend in a thickness direction of the circuit board.

10. The method of one of claims 7 to 9, wherein the connection portion protrudes from an inner wall of the at least one of the recess and the hole.

11. The method of one of claims 7 to 10, wherein the at least one of the recess and the hole is connected with the connector header by inserting the connector header therein.

12. The method of one of claims 7 to 11, the method further comprising:
preparing a combining target circuit board comprising a connector header having a combining target connection portion, a combining target terminal, and another conduction line for connecting the combining target terminal and the combining target connection portion; and
operatively connecting the at least one of the recess and the hole and the connector header by inserting the connector header into the at least one of the recess and the hole such that the connection portion is electrically connected to the combining target connection portion.
